Europäisches Patentamt

**European Patent Office**

**Office européen des brevets**

(11) Numéro de publication: **0 271 938 B1**

# FASCICULE DE BREVET EUROPEEN

(45) Date de publication de fascicule du brevet: **12.08.92**  (51) Int. Cl.⁵: **H03F 1/30**, H03G 3/20, H03G 1/00

(21) Numéro de dépôt: **87202234.8**

(22) Date de dépôt: **16.11.87**

(54) **Circuit d'amplification à contrôle automatique de gain.**

(30) Priorité: **18.11.86 FR 8615994**

(43) Date de publication de la demande:
**22.06.88 Bulletin 88/25**

(45) Mention de la délivrance du brevet:
**12.08.92 Bulletin 92/33**

(84) Etats contractants désignés:
**DE FR GB SE**

(56) Documents cités:
**FR-A- 1 548 146**
**GB-A- 2 001 221**
**GB-A- 2 117 203**

**PATENT ABSTRACTS OF JAPAN, vol. 10, no. 279 (E-439)[2335], 20 septembre 1986; & JP-A-61 99 405 (SANYO ELECTRIC CO. LTD) 17-05-1986**

**IEEE TRANSACTIONS ON BRAODCAST AND TELEVISION RECEIVERS, vol. BTR-13, no. 2, juillet 1967, pages 72-81, New York, US; H.M. KLEINMAN: "Application of dual-gate MOS field-effect transistors in practical radio receivers"**

(73) Titulaire: **PHILIPS COMPOSANTS**
**117, quai du Président Roosevelt**
**F-92130 Issy les Moulineaux(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB SE**

(72) Inventeur: **Guery, Alain Société Civile S.P.I.D.**
**209, rue de l'Université**
**F-75007 Paris(FR)**

(74) Mandataire: **Pinchon, Pierre et al**
**Société Civile S.P.I.D. 156, Boulevard Haussmann**
**F-75008 Paris(FR)**

## Description

La présente invention concerne un circuit d'amplification à liaison directe dont l'étage d'entrée est muni d'une commande de gain en vue de contrôler automatiquement le niveau de signal alternatif à une borne de sortie de ce circuit, dont le signal de sortie est appliqué à l'entrée d'une chaîne d'éléments en cascade qui comprend notamment un détecteur et un circuit intégrateur et qui fournit en sortie un signal pour la commande de gain de l'étage d'entrée, circuit qui comporte également des moyens pour la stabilisation, au moins sur la borne de sortie, du niveau de tension continue.

On se propose, dans un tel circuit d'amplification, d'utiliser un couplage direct entre les étages de sorte que la plus grande partie de ce circuit puisse être facilement construite sous la forme d'un circuit intégré.

On sait que dans le cas d'amplificateur à gain élevé, et à couplage direct, une petite variation de la tension de polarisation d'un étage peut aisément entraîner une saturation ou une coupure à l'un des étages suivants du fait que cette variation de tension se trouve amplifiée en même temps que le signal alternatif. A plus forte raison, lorsque l'étage d'entrée du circuit amplificateur comporte une commande pour faire varier le gain de cet étage en vue d'un contrôle automatique du niveau de signal en sortie, et que la commande de gain agit sur le point moyen de fonctionnement d'un transistor, il devient absolument nécessaire de prévoir des moyens particuliers pour stabiliser le niveau de tension continue de cet étage amplificateur ou de tout autre étage qui suit.

Un circuit amplificateur du type indiqué en préambule est connu notamment du document de brevet FR 1 548 146.

Si on se réfère au domaine d'application qui concerne l'amplification de signaux numériques très faibles, notamment tels que ceux qui sont formés à la sortie d'un détecteur placé à l'extrémité réceptrice d'une liaison par fibre optique, il apparaît que le circuit amplificateur connu ne satisfait pas convenablement aux exigences de cette application.

En effet, il serait souhaitable de pouvoir faire varier le gain de l'amplificateur dans une plage plus étendue de valeurs et de disposer d'un gain maximal plus élevé. Comme les moyens de stabilisation du niveau de tension continue, dans le circuit connu, aboutissent à une stabilité imparfaite de cette tension, et compte-tenu de la valeur élevée du gain recherché, il serait nécessaire de mettre en place des mêmes moyens à plusieurs étages d'amplification pour tenter d'obtenir une stabilité convenable en sortie. Cependant on aboutit alors à un nombre de composants exagérément élevé. Par ailleurs, les moyens de stabilisation de la tension continue, dans le circuit connu, n'agissent pas, comme il serait souhaitable, sur le niveau de la tension présentée par la borne active de la résistance de charge de l'étage d'entrée du circuit, mais sont disposés à l'étage suivant. Il s'ensuit une limitation gênante de la plage dynamique de fonctionnement du circuit en fonction de la variation de la polarisation de l'étage d'entrée.

Aussi l'invention, vise-t-elle à fournir un circuit d'amplification à contrôle automatique de gain qui soit bien adapté à l'amplification de signaux numériques très faibles, dont le gain maximal et la plage de variation de gain soient très élevés et qui fournisse en sortie un signal alternatif dont le niveau est maintenu entre des limites étroites, alors que la tension continue de polarisation, au moins sur la borne de sortie du circuit, soit fixée à une valeur constante.

Comme l'invention s'adresse à un circuit pour l'amplificateur de signaux qui peuvent être très faibles, elle vise en même temps à fournir une solution dans laquelle le niveau de bruit à la sortie de l'amplificateur soit le plus bas possible.

Selon la présente invention, un circuit d'amplification tel que défini en préambule est notamment caractérisé en ce que l'étage d'entrée du circuit d'amplification est constitué essentiellement par un transistor à effet de champ à deux grilles, l'une des deux grilles constituant l'électrode de commande de gain de cet étage, et le drain étant connecté à une borne active d'une résistance de charge, en ce que lesdits moyens de stabilisation du niveau de tension continue comportent :

- un générateur de courant continu débitant sur la borne active de la résistance de charge, un courant variant à l'opposé du courant moyen de sortie du transistor à effet de champ,

- un amplificateur différentiel à gain élevé dont une première entrée est connectée à la borne active de la résistance de charge, et une deuxième entrée connectée à une tension continue de référence,

- et un filtre passe-bas qui reçoit en entrée le signal d'une sortie de l'amplificateur différentiel et délivre en sortie un signal, pour une commande du générateur de courant dans un sens tel que le courant délivré par le générateur soit appliqué en contre-réaction sur la première entrée de l'amplificateur différentiel.

Un tel circuit assure une stabilisation de la tension continue de sortie d'autant meilleure que le gain de l'amplificateur différentiel est élevé. D'autre part les moyens de stabilisation selon l'invention agissent sur la tension de repos de la borne active de la résistance de charge de l'étage d'entrée. Le transistor à effet de champ de cet étage travaille donc à tension drain-source constante qui peut être choisie de manière à assurer une plage dynamique optimale de l'amplificateur.

Les caractéristiques du filtre passe bas sont aisément déterminées en tenant compte de la limite basse de la bande des fréquences à transmettre et du temps de réponse désiré de la stabilisation du niveau continu de sortie lorsqu'une variation brusque est appliquée à la commande de gain de l'étage d'entrée.

Dans le cas d'application du circuit selon l'invention où la commande de gain intervient par des variations lentes dans le temps, (réglage quasi statique tel qu'une compensation de vieillissement par exemple), le filtre passe-bas peut se réduire avantageusement à un simple circuit R-C à constante de temps grande vis-à-vis de la limite basse de la bande de fréquences à transmettre.

Le circuit amplificateur selon l'invention prévoit l'utilisation d'un transistor à effet de champ à deux grilles pour constituer l'étage d'entrée. Ceci offre l'avantage des excellentes performances en bruit que procure ce type de transistors et permet en même temps une commande de variation du gain de cet étage, qui est à la fois simple, progressive et relativement étendue.

Il est à noter que le signal alternatif amplifié peut être prélevé en tout point de la chaîne d'amplification depuis la borne active de la résistance de charge jusqu'à la sortie de l'amplificateur différentiel.

Cependant un mode préféré de mise en oeuvre de l'invention se caractérise en ce que, pour la stabilisation du niveau de tension continue, l'amplificateur différentiel étant divisé en au moins une portion d'entrée et une portion de sortie, la portion d'entrée, au moins, est utilisée pour amplifier également le signal alternatif. Ainsi la portion d'entrée de l'amplificateur différentiel amplifie simultanément le signal alternatif et l'écart de la tension continue de polarisation de la borne active de la résistance de charge par rapport à la tension de référence. Cette même portion d'entrée remplit donc deux fonctions et conduit à une économie de moyens. Ce mode de mise en oeuvre offre également l'avantage de présenter en un point intermédiaire d'amplification le signal alternatif préamplifié sous forme de deux signaux complémentaires ayant pratiquement la même tension de repos. De tels signaux se prêtent particulièrement bien à une amplification supplémentaire, si nécessaire, au moyen d'un ou plusieurs étages différentiels à couplage direct.

L'invention sera mieux comprise par la description détaillée qui suit, en regard des diagrammes schématiques annexés, dans lesquels :

- la figure 1 donne un schéma de principe d'une portion du circuit d'amplification selon l'invention, portion qui est relative aux moyens de stabilisation du niveau de tension continue de l'étage d'entrée et,
- la figure 2 indique le schéma d'un exemple de réalisation du circuit d'amplification à contrôle automatique de gain selon l'invention.

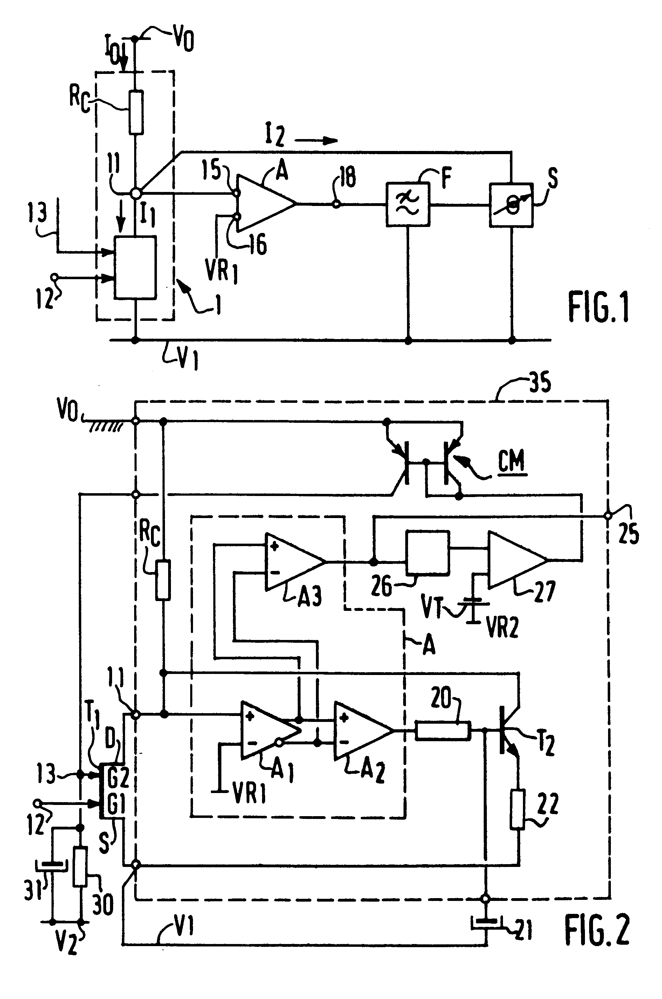

La figure 1 est plus particulièrement destinée à décrire les moyens de stabilisation de la tension continue tels qu'ils sont utilisés dans le circuit d'amplification selon l'invention. Cette figure montre un étage d'entrée 1 délivrant un signal préamplifié sur une borne active 11 d'une résistance de charge Rc. Il est alimenté à partir des deux bornes de tension d'alimentation $V_0$ et $V_1$. L'étage d'entrée 1, possède une borne d'entrée de signal 12 ainsi qu'une commande de gain 13 pouvant faire varier le gain de cet étage d'entrée par variation du point de fonctionnement d'au moins un transistor de cet étage. L'étage d'entrée 1 est du genre selon lequel la commande de gain produit une variation concomitante du courant moyen de sortie de cet étage appliqué à la résistance de charge Rc, de telle sorte que la tension présentée par la borne active 11 de la résistance de charge Rc a un niveau de tension continu qui varie dans de larges proportions en l'absence de tout autre moyen de compensation. Pour effectuer une stabilisation du niveau continu moyen sur la borne active 11 de la résistance de charge Rc on a associé à ce circuit un générateur de courant S commandé de telle sorte que son courant varie à l'opposé du courant moyen de sortie de l'étage d'entrée, ce courant étant également appliqué à la résistance de charge Rc de sorte que la somme $I_0$ des courants $I_1$ traversant l'étage d'entrée 1 et $I_2$ débité par le générateur de courant S, soit constante.

Les moyens de stabilisation du niveau continu de sortie de l'étage d'entrée 1 comportent en outre un amplicateur différentiel A à gain élevé, dont une première entrée 15 est connectée à la borne active 11 de la résistance de charge Rc et une deuxième entrée 16 est connectée à une tension continue de référence VR1. Un filtre passe-bas F reçoit sur son entrée le signal de sortie de l'amplificateur différentiel A et délivre en sortie un signal pour la commande du générateur de courant S, l'entrée 15 ou l'entrée 16 de l'amplificateur différentiel A étant choisie non-inverseuse ou inverseuse de manière à ce que le courant délivré par le générateur de courant S soit appliqué en contre-réaction sur la première entrée 15 de l'amplificateur différentiel A. La tension de la borne active 11 de la résistance de charge Rc a donc un niveau continu qui se trouve d'autant plus stabilisé que le gain de l'amplificateur différentiel A est élevé. En cas de besoin on pourrait également interposer entre le filtre passe-bas F et le générateur de courant S un amplificateur supplémentaire améliorant encore le degré de stabilité de la borne active 11 sans être gêné par le signal alternatif amplifié.

Le générateur de courant S peut être un transistor bipolaire dont l'impédance de collecteur sera grande devant la valeur de la résistance de charge Rc, et ne perturbera pas le signal amplifié.

La fréquence de coupure du filtre passe-bas F est choisie en tenant compte du temps de réponse désiré pour la stabilisation du niveau continu de la borne active 11 compte tenu de la limite basse de la gamme des fréquences à transmettre. Le signal amplifié peut être prélevé soit sur la borne active 11 de la résistance de charge Rc soit encore sur la borne de sortie 18 de l'amplificateur différentiel A soit encore et de préférence en un point intermédiaire d'amplification au sein de l'amplificateur différentiel A, ce dernier étant partagé en plusieurs étages d'amplification.

La figure 2 présente le schéma d'un exemple de réalisation d'un circuit d'amplification avec contrôle automatique de gain conforme à l'invention. En ce qui concerne la partie du circuit relative aux moyens de stabilisation de la tension continue, des repères numériques identiques à ceux de la figure 1 ont été utilisés pour des éléments semblables ayant la même fonction.

L'étage d'entrée du circuit amplificateur est ici constitué d'un transistor $T_1$ à effet de champ à deux grilles $G_1$, $G_2$, la grille $G_1$ étant connectée à la borne d'entrée de signal 12 et la grille $G_2$ recevant la commande de gain 13. Le drain du transistor $T_1$ est relié à la tension d'alimention $V_0$ via la résistance de charge Rc. Comme il est connu, on peut faire varier le gain du transistor $T_1$ dans de très grandes proportions en agissant sur la grille $G_2$ ce qui entraîne que le courant continu de repos de ce transistor varie également dans de larges proportions. Pour compenser ces variations, un transistor $T_2$ est disposé en générateur de courant dont le collecteur est relié à la borne active 11 de la résistance de charge Rc et également à l'entrée non-inverseuse de l'amplificateur différentiel A. Celui-ci, pour des raisons qui sont expliquées ultérieurement, est divisé en deux portions, une portion d'entrée $A_1$, et une portion de sortie $A_2$ tandis qu'à la sortie de la portion $A_2$ le filtre passe-bas est ici simplement constitué par une résistance 20 en série dans la base du transistor $T_2$ et un condensateur 21 connecté en parallèle entre la base du transistor $T_2$ et la tension d'alimentation $V_1$. Il est à noter qu'en général, la résistance 20 peut être constituée, en fait, par la résistance de sortie de la portion $A_2$ de l'amplificateur différentiel A. On a également fait figurer une résistance 22 en série dans l'émetteur du transistor $T_2$, résistance qui améliore la linéarité de fonctionnement du circuit mais cette résistance n'est pas strictement indispensable et dépend des caractéristiques de l'amplificateur différentiel A. L'amplificateur différentiel A comporte une troisième portion $A_3$ dont l'entrée de signal est connectée à un stade intermédiaire d'amplification entre les portions $A_1$ et $A_2$ d'amplificationet délivre sur la borne de sortie 25 le signal alternatif amplifié par le circuit d'amplification.

Le prélèvement du signal alternatif à un stade intermédiaire d'amplification est avantageux lorsque la résistance 20 du filtre passe-bas de type R-C est constituée par l'impédance de sortie de la portion d'amplification $A_2$. Le dispositif de contrôle automatique de gain est complété par un détecteur de crête 26 connecté à la sortie de la troisième portion $A_3$ de l'amplificateur différentiel suivi d'un comparateur 27. Le niveau de signal à la sortie du détecteur 26 qui se réfère à une tension de référence VR2 est comparé à celle-ci augmenté d'une tension de seuil VT. Le signal de sortie du comparateur 27 est un courant proportionnel à l'écart de tension à l'entrée de ce comparateur. Ce courant commande un miroir de courant CM référencé à la tension d'alimentation $V_0$, qui délivre le courant recopié sur une résistance de polarisation 30 connectée par ailleurs à une tension d'alimentation $V_2$, qui pour des raisons de commodité, peut être différente de la tension d'alimentation $V_1$.

En parallèle sur la résistance de polarisation 30 est connecté un condensateur 31 qui forme avec la résistance 30 un circuit intégrateur de type R-C, la tension développée sur ce circuit intégrateur étant appliquée à la commande de gain du transistor $T_1$ sur la grille 2. La constante de temps du contrôle automatique de gain est choisie de préférence de valeur inférieure à la constante de temps du filtre d'asservissement constitué par la résistance 20 et le condensateur 21. La commande de gain au moyen d'un miroir de courant est avantageuse du fait qu'elle permet une très grande variation de tension de commande, en combinaison avec la possibilité de réglage de la tension d'alimentation $V_2$ par rapport à la tension d'alimentation $V_1$.

Dans la réalisation représentée à la figure 2, le circuit intégrateur ou encore passe-bas nécessaire à la commande de gain est réalisé après la sortie du comparateur 27. Cependant, il est clair que ce circuit pourrait tout aussi bien être interposé entre le détecteur de crête 26 et le comparateur 27.

Avantageusement, le dispositif de la figure 2 est réalisé pour sa part essentielle sous forme d'un circuit intégré monolithique, la partie intégrée étant représentée à l'intérieur du cadre en tirets 35. Le transistor $T_1$ est de préférence un transistor à effet de champ à l'arséniure de gallium qui présente d'excellentes caractéristiques de bruit et de fréquence de coupure. Pour cette raison il est placé à l'extérieur de la partie intégrée représentée dans le cadre 35, laquelle partie est réalisée en silicium selon une technologie apparentée à la logique ECL. La résistance de polarisation 30 qui a été présentée comme élément extérieur de la partie intégrée peut dans certains cas, et si on le désire, être intégrée.

Un circuit d'amplification avec contrôle automatique de gain tel que représenté à la figure 2, est particulièrement bien adapté à l'amplification de signaux numériques tels qu'ils apparaissent à la sortie d'un détecteur de fibre optique pour des communications numériques à une vitesse de 140 Mbits/sec.

## Revendications

1. Circuit d'amplification à liaison directe dont l'étage d'entrée (1, $T_1$) est muni d'une commande de gain en vue de contrôler automatiquement le niveau de signal alternatif à une borne de sortie de ce circuit (18, 25), dont le signal de sortie est appliqué à l'entrée d'une chaine d'éléments en cascade qui comprend notamment un détecteur (26) et un circuit intégrateur (30, 31) et qui fournit en sortie un signal pour la commande de gain de l'étage d'entrée, circuit qui comporte également des moyens pour la stabilisation, au moins sur la borne de sortie, du niveau de tension continue, caractérisé en ce que l'étage d'entrée du circuit d'amplification est constitué essentiellement par un transistor à effet de champ à deux grilles ($T_1$), l'une des deux grilles ($G_2$) constituant l'électrode de commande de gain de cet étage, et le drain (D) étant connecté à une borne active (11) d'une résistance de charge ($R_C$), en ce que lesdits moyens de stabilisation du niveau de tension continue comportent :
   - un générateur de courant continu (S ; $T_2$, 22) débitant sur la borne active (11) de la résistance de charge ($R_C$), un courant variant à l'opposé du courant moyen de sortie du transistor à effet de champ ($T_1$),
   - un amplificateur différentiel à gain élevé (A : $A_1$, $A_2$, $A_3$) dont une première entrée (15 ; $A_1$, " + ") est connectée à la borne active (11) de la résistance de charge ($R_C$), et une deuxième entrée (16 ; $A_1$, "- ") connectée à une tension continue de référence ($VR_1$),
   - et un filtre passe-bas (F : 20, 21) qui reçoit en entrée le signal d'une sortie de l'amplificateur différentiel et délivre en sortie un signal, pour une commande du générateur de courant (S : $T_2$, 22) dans un sens tel que le courant délivré par le générateur soit appliqué en contre-réaction sur la première entrée de l'amplificateur différentiel (15 : $A_1$, " + ").

2. Circuit d'amplification selon la revendication 1 caractérisé en ce que, pour la stabilisation du niveau de tension continue, l'amplificateur différentiel étant divisé en au moins une portion d'entrée ($A_1$) et une portion de sortie ($A_2$, $A_3$), la portion d'entrée ($A_1$), au moins, est utilisée pour amplifier également le signal alternatif.

3. Circuit d'amplification selon l'une des revendications 1 ou 2 caractérisé en ce que ladite chaîne des éléments en cascade fournissant le signal de commande de gain, comporte un comparateur (27) délivrant un courant proportionnel à l'écart entre d'une part, le signal de sortie après détection et, d'autre part, une tension de référence ($VR_2$) augmentée d'une tension de seuil ($V_T$).

4. Circuit d'amplification selon la revendication 3 caractérisé en ce que le courant de sortie du comparateur est transformé en tension de commande de la deuxième grille du transistor à effet de champ par l'effet d'un miroir de courant (CM) alimentant une résistance de polarisation (30), et en ce que ledit circuit d'intégration de la chaîne d'éléments est constitué par un condensateur (31) en parallèle sur cette résistance de polarisation.

## Claims

1. Direct-link amplifier circuit whose input stage (1, $T_1$) comprises a gain control for automatically controlling the level of the AC signal at an output terminal of this circuit (18, 25), the output signal of which is applied to the input of a chain of cascaded elements which includes, more specifically, a detector (26) and an integrator (30, 31) and which supplies at its output a signal for the gain control of the input stage, which circuit likewise includes means for stabilizing the DC voltage level at least at the output terminal, characterized in that the input stage of the amplifier circuit is constituted, in essence, by a dual-gate field effect transistor ($T_1$), one of the two gates ($G_2$) forming the gain control electrode of this stage, and the drain (D) being connected to an active terminal (11) of a load resistor ($R_C$), in that said means for stabilizing the DC voltage level comprise:
   - a DC current generator (S ; $T_2$, 22) delivering at the active terminal (11) of the load resistor ($R_C$) a current which varies contrary to the mean output current of the field effect transistor ($T_1$),

- a high gain differential amplifier (A ; $A_1$, $A_2$, $A_3$), a first input of which (15; $A_1$, " + ") being connected to the active terminal (11) of the load resistor ($R_C$) and a second input (16; $A_1$, "-") being connected to a reference DC voltage ($VR_1$),

- and a low-pass filter (F ; 20,21) receiving at the input the output signal of the differential amplifier and supplying at its output a signal for a current generator control (S ; $T_2$, 22) in such a way that the current supplied by the generator is applied as a negative feedback to the first input of the differential amplifier (15; $A_1$, " + ").

2. Amplifier circuit as claimed in Claim 1, characterized in that for stabilizing the DC voltage level, the differential amplifier being subdivided into at least one input section ($A_1$) and one output section ($A_2$, $A_3$), at least the input section ($A_1$) is used for amplifying also the AC signal.

3. Amplifier circuit as claimed in one of the Claims 1 or 2, characterized in that said chain of cascaded elements supplying the gain control signal comprises a comparator (27) which delivers a current proportional to the difference between, on the one hand, the output signal after detection and, on the other hand, a reference voltage ($VR_2$) augmented by a threshold voltage ($V_T$).

4. Amplifier circuit as claimed in Claim 3, characterized in that the output current of the comparator is transformed into a control voltage of the second gate of the field effect transistor by means of a current mirror circuit (CM) feeding a bias resistor (30), and in that said integrator of the chain of elements is constituted by a capacitor (31) connected in parallel with this bias resistor.

**Patentansprüche**

1. Verstärkerschaltung in direkter Verbindung, deren Eingangsstufe (1, $T_1$) mit einer Verstärkungsregelung zur automatischen Steuerung des Wechselstromsignalpegels an einer Ausgangsklemme dieser Schaltung (18, 25) versehen ist, deren Ausgangssignal dem Eingang einer Kette in Kaskade geschalteter Elemente zugeführt wird, die insbesondere einen Detektor (26) und eine Integratorschaltung (30, 31) enthält und die am Ausgang ein Signal zur Verstärkungsregelung der Eingangsstufe liefert, welche Schaltung zugleich Mittel zur Stabilisierung des Gleichspannungspegels, mindestens an der Ausgangsklemme, enthält, dadurch gekennzeichnet, daß die Eingangsstufe der Verstärkerschaltung im wesentlichen aus einem Feldeffekttransistor ($T_1$) mit zwei Gate-Elektroden besteht, wobei eine der beiden Gate-Elektroden (G3) die Elektrode zur Verstärkungsregelung dieser Stufe bildet, und die Drain-Elektrode (D) mit einem aktiven Anschluß (11) eines Lastwiderstandes ($R_C$) verbunden ist, und daß diese Mittel zur Stabilisierung des Gleichspannungspegels die folgenden Elemente aufweisen:

- einen Gleichstromgenerator (S; $T_2$, 22), der Strom an den aktiven Anschluß (11) des Lastwiderstandes ($R_C$) liefert, welcher Strom im Vergleich zum mittleren Ausgangsstrom des Feldeffekttransistors ($T_1$) schwankt,

- einen Differentialverstärker mit hoher Verstärkung ($A_i$,$A_1$, $A_2$, $A_3$), dessen erster Eingang (15; $A_1$, " + ") mit dem aktiven Anschluß (11) des Lastwiderstandes ($R_C$) und dessen zweiter Eingang (16; $A_1$,"-") mit einer Bezugsgleichspannung ($VR_1$) verbunden ist, und

- einen Tiefpaß (F; 20, 21), der am Eingang das Signal eines Ausgangs des Differentialverstärkers empfängt und am Ausgang zur Steuerung des Stromgenerators (s; $T_2$, 22) ein solches Signal liefert, daß der von dem Generator gelieferte Strom in Gegenkopplung dem ersten Eingang des Differentialverstärkers (15; $A_1$, " + ") zugeführt wird.

2. Verstärkerschaltung nach Anspruch 1, dadurch gekennzeichnet, daß zur Stabilisierung des Gleichspannungspegels, wobei der Differentialverstärker in mindestens ein Eingangsteil ($A_1$) und ein Ausgangsteil ($A_2$, $A_3$) unterteilt ist, mindestens der Eingangsteil ($A_1$) zugleich zum Verstärken des Wechselstromsignals verwendet wird.

3. Verstärkerschaltung nach einem der Ansprüche 1 oder 2, dadurch gekennzeichnet, daß die Kette in Kaskade geschalteter Elemente, die das Signal zur Verstärkungsregelung liefern, einen Komparator (27) enthält, der einen Strom liefert, der proportional zum Unterschied zwischen dem Ausgangssignal nach der Detektion einerseits und einer um eine Schwellenspannung ($V_T$) erhöhte Bezugsspannung ($VR_2$) andererseits ist.

4. Verstärkerschaltung nach Anspruch 3, dadurch gekennzeichnet, daß der Ausgangsstrom des Komparators in eine Steuerspanung der zweiten Gate-Elektrode des Feldeffekttransistors mittels des Effektes eines Stromspiegels (CM), der einen Vorspannungswiderstand (30) speist, umgesetzt wird, und daß die Integrationsschaltung der Elementekette von einem Kondensator (31) parallel zu diesem Vorspannungswiderstand gebildet wird.

EP 0 271 938 B1

FIG.1

FIG.2